# EUROPEAN PATENT APPLICATION

(11) **EP 4 693 297 A1**
(43) Date of publication of application: **11.02.2026**
(21) Application number: 25192061.7
(22) Date of filing: 28.07.2025
(51) Int. Cl.: G11C 16/10, G11C 16/04

(54) **MEMORY CONTROLLER AND OPERATION METHOD THEREOF**

(30) Priority: 09.08.2024 KR 20240107064
(71) Applicant: Samsung Electronics Co., Ltd., Suwon-si, Gyeonggi-do 16677 (KR)
(72) Inventor: JO, Taegwang, Suwon-si, Gyeonggi-do 16677 (KR)
(74) Representative: Kuhnen & Wacker Patent- und Rechtsanwaltsbüro PartG mbB

(57) **Abstract**

A memory controller (100) controlling a memory device (110) includes a plurality of chips (111). An operation method of the memory controller (100) includes generating a first program command including information on a plurality of starting word lines at different positions in a plurality of target blocks corresponding to the plurality of chips (111), and transmitting the first program command to the memory device (110).

## Description

### BACKGROUND

Some example embodiments relate to a memory controller and/or an operation method thereof.

A memory device used to store data may include a volatile memory device and a non-volatile memory device. As an example of the non-volatile memory device, a flash memory device may be used in one or more of a mobile phone, a digital camera, a personal digital assistant (PDA), a mobile computer device, a fixed computer device, and another device.

### SUMMARY

Some example embodiments may provide a memory controller for minimizing or reducing power consumed in a program operation for a plurality of chips included in a memory device, and/or an operation method thereof.

However, the goals to be achieved by example embodiments are not limited to the objectives described above and other objects may be clearly understood from some following example embodiments.

For example, there is provided an operation method of a memory controller configured to control a memory device including a plurality of chips, the operation method including generating a first program command including information on a plurality of starting word lines at different positions in a plurality of target blocks corresponding to the plurality of chips, and transmitting the first program command to the memory device.

For example, there is provided a non-transitory computer-readable recording medium in which a program for executing the operation method of the memory controller in a computer is stored.

For example, there is provided a memory controller configured to control a memory device including a plurality of chips, the memory controller including a memory interface configured to communicate with the memory device, and a processor configured to generate a program command including information on a plurality of starting word lines in a plurality of target blocks at different positions, the plurality of target blocks corresponding to the plurality of chips, the processor configured to transmit the program command to the memory device through the memory interface.

For example, there is provided a memory system including a memory device including a plurality of chips, and a memory controller. Each of the plurality of chips includes a plurality of blocks. The memory controller includes a memory interface configured to communicate with the memory device, and a processor configured to generate a program command including information on a plurality of starting word lines in a plurality of target blocks at different positions corresponding to the plurality of chips and to transmit the program command to the memory device through the memory interface.

For example, one or more of the following effects may be expected.

For example, a memory controller may control a plurality of chips so that a program operation starts at starting word lines at different positions in the plurality of target blocks. For example, since positions of word lines simultaneously programmed in the plurality of chips are dispersed, power consumed in the program operation for the plurality of chips may be reduced or minimized.

Effects of some example embodiments are not limited to those described above and other effects may be made apparent to those of ordinary skill in the art from the following description of the accompanying claims.

### BRIEF DESCRIPTION OF THE DRAWINGS

These and/or other aspects, features, and advantages of the invention will become apparent and more readily appreciated from the following description of some example embodiments, taken in conjunction with the accompanying drawings of which:
FIG. 1 is a diagram for describing a memory controller according to some example embodiments;
FIG. 2 is a diagram for describing a memory system including a memory controller and a memory device according to some example embodiments;
FIG. 3 is a diagram for describing power consumed in a program operation for a word line according to some example embodiments;
FIG. 4 is a diagram for describing in detail an operation of a memory controller according to some example embodiments transmitting a first program command to each of a plurality of chips;
FIG. 5 is a perspective diagram illustrating a block included in a chip according to some example embodiments;
FIG. 6 is a diagram for describing a program operation according to a second program command and a program operation according to a first program command according to some example embodiments;
FIG. 7 is a diagram for describing a program operation according to a second program command and a program operation according to a first program command according to some example embodiments;
FIG. 8 is a diagram for describing an erasure operation according to an erasure command according to some example embodiments;
FIG. 9 is a diagram for describing a program operation according to a third program command according to some example embodiments;
FIG. 10 is a diagram for describing a method with which a memory controller controls a program operation for a plurality of chips when a target block according to some example embodiments includes a plurality of sub-blocks;
FIG. 11 is a block diagram illustrating an example in which a memory device according to some example embodiments is applied to a solid state drive (SSD) system; and
FIG. 12 is a flowchart for describing an operation method of a memory controller according to some example embodiments.

### DETAILED DESCRIPTION

Terms used in some example embodiments are selected, as much as possible, from general terms that are widely used at present while taking into consideration the functions obtained in accordance with the present disclosure, but these terms may be wholly or partially replaced by other terms based on intentions of those of ordinary skill in the art, customs, emergence of new technologies, or the like. In a particular case, terms that are arbitrarily selected may be used. In this case, the meanings of these terms may be described in corresponding description parts of the herein. Accordingly, it should be noted that the terms used herein should be construed based on practical meanings thereof and the whole content of this specification, rather than being simply construed based on names of the terms.

In the entire specification, when an element is referred to as "including" another element, the element should not be understood as excluding other elements so long as there is no special conflicting description, and the element may include at least one other element. In addition, the terms "unit" and "module", for example, may refer to a component that exerts at least one function or operation, and may be realized in hardware or software, or may be realized by combination of hardware and software.

In the following description, some example embodiments will be described in detail with reference to the accompanying drawings so that those of ordinary skill in the art can easily carry out the present disclosure. However, example embodiments be embodied in many different forms and are not limited to the example embodiments described herein.

Hereinafter, some example embodiments of the present disclosure will be described with reference to the accompanying drawings.

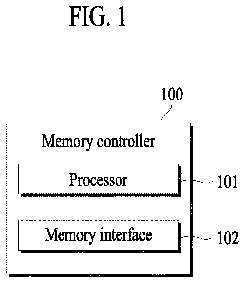

FIG. 1 is a diagram for describing a memory controller according to some example embodiments.

Referring to FIG. 1, a memory controller 100 according to some example embodiments may include a processor 101 and a memory interface 102. Here, the memory controller 100 may be or may include, or be included in, a device for controlling various operations for a memory device including a plurality of chips. For example, the memory controller 100 may control one or more of a program operation, a reading operation, and an erasure operation for the memory device.

The processor 101 according to some example embodiments may control some or all, e.g. the overall operations of the memory controller 100. The processor 101 may control the program operation for the memory device. For example, the processor 101 may generate a program command including information on a plurality of starting word lines (or, starting rows) at different positions, e.g., different physical positions and/or different virtual positions, in a plurality of target blocks corresponding to the plurality of chips, and may transmit the program command to the memory device through the memory interface 102. Here, the program command may include a plurality of program commands for each of the plurality of chips. In some example embodiments, the processor 101 may individually control a program operation for each of the plurality of chips by transmitting each of the plurality of program commands to a corresponding chip through the memory interface 102.

The memory interface 102 according to some example embodiments may be a device for allowing an interaction between the memory controller 100 and an external device. Further, the memory interface 102 may be or include, or be included in, an interface for allowing an interaction between the memory controller 100 and the memory device and may be connected to one or more, e.g., each of, an address (ADDR) pin, a command (CMD) pin, a data (DATA) pin, and a control (CTRL) pin. The processor 101 may communicate with the memory interface 102 through a bus, such as a wired and/or a wireless bus, to transfer information such as but not limited to analog and/or digital information, for example in a one-way and/or two-way and/or broadcast manner. The information may be commands and/or other data; example embodiments are not limited thereto.

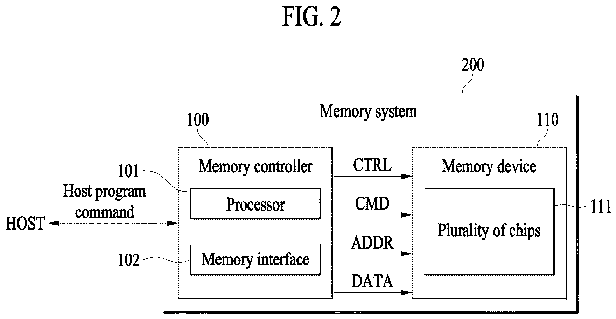

FIG. 2 is a diagram for describing a memory system including a memory controller and a memory device according to some example embodiments.

Referring to FIG. 2, a memory system 200 according to some example embodiments may include the memory controller 100 and a memory device 110. The memory controller 100 may include the processor 101 and the memory interface 102. The memory device 110 may include a plurality of chips 111.

In response to receiving a host program command from a host, the memory controller 100 may generate a program command for or associated with the ordering of a program operation for the plurality of chips 111 included in the memory device 110. In some example embodiments, the program command may refer to a command transmitted from the memory controller 100 to the memory device 110. For example, the program command may be distinguished from the host program command which is transmitted from the host. The host program command may be or may include a command for or associated with ordering a program operation for the memory device 110 and transmitted to the memory controller 100 one time. In contrast, the program command generated in the memory controller 100 may be transmitted to each of the plurality of chips 111 several times.

Although not illustrated in FIG. 2, the memory controller 100 may further include a volatile memory and a host interface. For example, the volatile memory may be or may include a random access memory (RAM) such as a dynamic RAM (DRAM) and/or a static RAM (SRAM), but it is merely an example. The volatile memory may be used as an operation memory of the memory controller 100. For example, the volatile memory may store data to be stored in a memory cell of the memory device 110. Alternatively or additionally, the host interface may be or may include a device for allowing an interaction between the host and the memory controller 100. In this regard, the memory controller 100 may be configured to communicate with the host through at least one of various interface protocols such as one or more of a universal serial bus (USB), MultiMediaCard (MMC), Peripheral Component Interconnect Express (PCI-E), advanced technology attachment (ATA), serial-ATA, parallel-ATA, Small Computer System Interface (SCSI), Enhanced Small Disk Interface (ESDI), a universal flash storage (UFS), Non-Volatile Memory Express (NVMe), and Integrated Drive Electronics (IDE).

The memory device 110 according to some example embodiments may include the plurality of chips 111. Here, each of the plurality of chips 111 may include a plurality of memory cells. Each of the plurality of memory cells may be or may include a flash memory cell. Hereinafter, some example embodiments will be described with an example in which a chip is formed of a plurality of flash memory cells. However, example embodiments are not limited thereto. In some example embodiments, the memory cells may be or may include a resistive memory cell such as one or more of a resistive RAM (RRAM), a phase change RAM (PRAM), or a magnetic RAM (MRAM).

According to some example embodiments, the chip may include a plurality of blocks. Each of the plurality of blocks may have the same capacity; however, example embodiments are not limited thereto, and at least one block from among the plurality of blocks may have a different memory capacity than at least another block from among the plurality of blocks. The program operation may be performed only for one block among the plurality of blocks included in the chip. For example, the program operation may not be simultaneously performed for two or more blocks among the plurality of blocks included in the chip. In contrast, the program operation may be simultaneously performed for a first target block included in a first chip and a second target block included in a second chip. In this regard, a plurality of target blocks that is a target of the program operation may individually correspond to one of the plurality of chips 111. In some example embodiments, a target block may refer to a block to be programmed by the program command among the plurality of blocks.

According to some example embodiments, the memory controller 100 may transmit one or more of address information, command, data, and a signal through one or more of an address line, a command line, a data line, and a control line that are connected to one or more of an address (ADDR) pin, a command (CMD) pin, a data (DATA) pin, and a control (CTRL) pin, e.g., may respectively transmit address information, command, data, and a signal through the ADDR pin, the CMD pin, the DATA pin, and the CTRL pin. The memory controller 100 may transmit various signals such as a signal showing a start and/or an end of an operation in the memory device 110 and a signal that activates a chip included in the memory device 110 through the control line connected to the control pin. The memory controller may transmit various commands such as the program command, a reading command, and an erasure command for the memory device through a command line connected to the command pin. The memory controller 100 may transmit address information associated with a command through the address line connected to the address pin. For example, since the program operation may be performed for each word line of a block included in the chip, the memory controller may transmit information on a word line through the address line. The memory controller 100 may transmit data information associated with the command through the data line connected to the data pin. For example, when the command is the program command, the memory controller 100 may transmit data information to be stored in the memory cell of the memory device 110 through the data line.

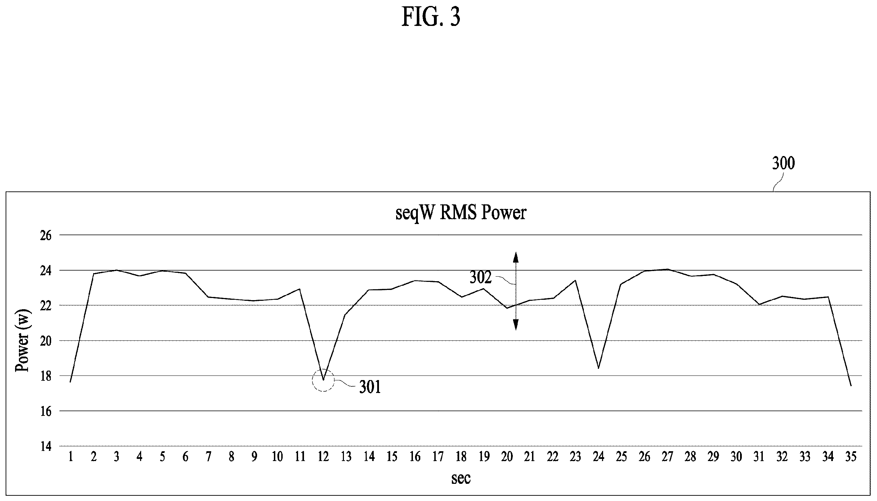

FIG. 3 is a diagram for describing power consumed in a program operation for a word line according to some example embodiments.

Referring to FIG. 3, a graph 300 shows a change in power consumption over time at a time at which a program operation for a specific (e.g., a predetermined) word line of a target block is performed. In particular, the graph 300 shows the change in the power consumption according to the program operation being sequentially performed for each of a plurality of memory cells included in the predetermined word line.

According to some example embodiments, a memory cell included in each of a plurality of chips may correspond to one of a single level cell, a multi-level cell, a triple-level cell, and a quad-level cell, but this is merely an example. The memory cell included in each of the plurality of chips may correspond to a high-level cell for storing data having more bits than that stored in the quad-level cell. The single level cell may store one-bit data. The multi-level cell may store two-bit data. The triple-level cell may store three-bit data. The quad-level cell may store four-bit data. For example, as a level of the memory cell is increased from a single level to a quad level, power consumed in performing the program operation for the memory cell may be high, but more data may be stored. In some example embodiments, each of or at least some of the plurality of chips may have, as a feature, the quad-level cell which stores the four-bit data. Alternatively or additionally, each of or at least some of the plurality of chips may have, as a feature, the high-level cell which stores four or more-bit data.

Referring to an area 301, power consumption of a first memory cell may show a value relatively lower than power consumption of another memory cell. In this regard, the first memory cell may correspond to one of the multi-level cell which stores the two-bit data and the triple-level cell which stores the three-bit data. In contrast, referring to the graph 300, power consumption of most memory cells may be within a range from approximately 22 watts (W) to approximately 24 W. A memory cell of which power consumption is within such range may be the quad-level cell. Referring to an area 302, power consumption quad-level cells may have a difference of approximately 2 W.

Maximum average power of a chip may be an average value (e.g., a mean value, a median value, or a mode value) of power consumed in the chip for a particular (e.g., a predetermined) time. In this regard, in order to increase power efficiency and a life of the chip, an upper limit on the maximum average power for the chip may be set in chip designing. As described above, since a chip including multiple quad-level cells may have maximum average power relatively higher than that of a chip including a smaller number of quad-level cells and/or including single-level, multi-level, or triple-level cells, there may be a concern that the maximum average power of the chip including the multiple quad-level cells exceeds the set upper limit. At this point, there may be a concern that performance of the program operation for the chip deteriorates as the maximum average power of the chip is adjusted so as not to exceed the upper limit. For example, when power according to the program operation for the plurality of chips 111 is reduced or minimized, the performance of the program operation for the chip may be improved together. In this regard, an operation method of the memory controller 100 for reducing or minimizing the power according to the program operation for the plurality of chips 111 which is included in the memory device 110 will be described.

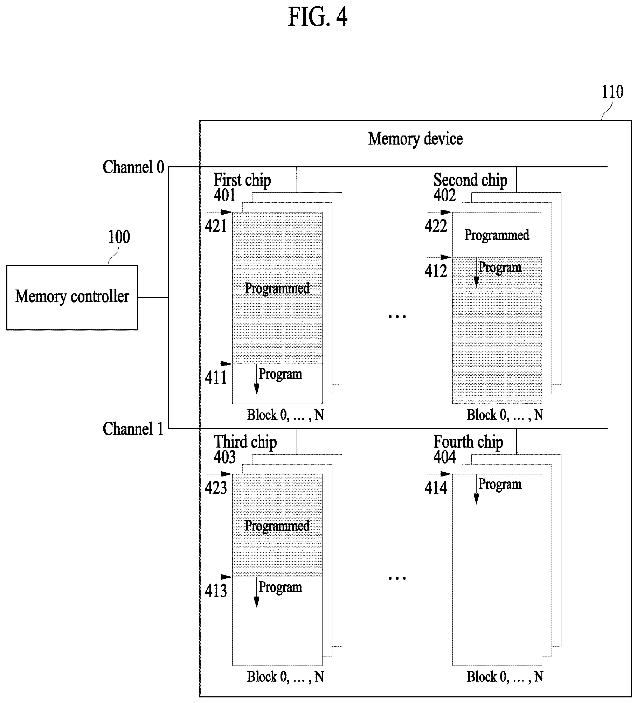

FIG. 4 is a diagram for describing in detail an operation of a memory controller according to some example embodiments transmitting a first program command to each of a plurality of chips.

A plurality of blocks included in a chip may be blocks produced to have identical specifications. For example, two blocks included in the plurality of chips may be substantially identical blocks. In this regard, power consumed according to a program operation for specific or predetermined word lines of the blocks in the memory device 110 may show greatly similar values. In contrast, power consumed in a program operation for different word lines in the block may show different values. In this regard, a different numbers of single level cells, multi-level cells, triple-level cells, and quad-level cells included in each word line may be one of reasons as to why power consumed for each word line shows different values.

Generally, a program operation for a target block may be performed in a first direction or a second direction from an edge word line of the target block. In some example embodiments, an edge word line may be or may correspond to a home word line, such as a word line corresponding to one of an uppermost word line or uppermost physically active word line of the block, or a lowermost word line or lowermost physically active word line of the block. For example, the program operation for the target block may correspond to one of a top-down program operation performed from an uppermost word line of the target block, or a bottom-up program operation performed from lowermost word lines of target blocks. The first direction may be a direction from the uppermost word line toward the lowermost word line and correspond to a downward direction in the top-down program operation. The second direction may be a direction from the lowermost word line toward the uppermost word line and correspond to an upward direction in the bottom-up program operation.

In contrast, a program operation according to some example embodiments may be performed in the first direction or the second direction from a plurality of starting word lines at different position, e.g., different physical positions, from among a plurality of target blocks. In the present disclosure, a starting word line may refer to a word line at which the program operation starts in the target block. In this regard, since the program operation according to some example embodiments is performed from the plurality of starting word lines at the different positions in the plurality of target blocks, an interval such as a specific, or alternatively, predetermined interval between respective word lines of each of the plurality of chips may be maintained during performance of the program operation. For example, unlike a scheme of programming word lines having high power consumed according to a program operation together and programming word lines having lower power consumed according to the program operation together, the program operation according to some example embodiments may program a word line having high power consumed according to the program operation and a word line having lower power consumed according to the program operation, together (e.g., concurrently or at least partly concurrently). In this regard, maximum power consumption according to the program operation according to some example embodiments may be lower than maximum power consumption according to a program operation performed from starting word lines at equal positions. For example, the maximum power consumption according to the program operation according to some example embodiments may be 23.8 W, the maximum power consumption according to the program operation performed from the starting word lines at the equal positions may be 24.5 W, and accordingly, the maximum power consumption may be improved by 0.7 W.

In some example embodiments, the first program command may be or may correspond to a program command including information on the plurality of starting word lines at the different positions or different physical positions in the plurality of target blocks. In this regard, the first program command may be a program command for ordering a program operation in the first direction or the second direction from the plurality of starting word lines which corresponds to the plurality of target blocks. For example, as each of the plurality of chips receives the first program command, the program operation may individually start at the starting word lines at the different positions in the plurality of target blocks. Here, the number of word lines between two starting word lines among the plurality of starting word lines may be greater than or equal to a particular (e.g., a predetermined) number. The number may be stored, e.g., within the memory controller 100, such as within firmware in the memory controller 100 and/or within the memory device 110, such as within one of first to fourth chips 401-404; example embodiments are not limited thereto.

Also, an interval between a plurality of word lines programmed individually in the plurality of chips may be maintained during performance of the program operation. In this regard, the first program command may include information on a set ratio corresponding to the number of word lines to be programmed in each of the plurality of chips. In this regard, a first ratio that is set for a first chip among the plurality of chips and a second ratio that is set for a second chip among the plurality of chips may correspond to an equal value. For example, the program operation according to the first program command may have, as a feature, programming an equal number of word lines in each of the plurality of target blocks.

Referring to FIG. 4, the memory device 110 may include a first chip 401, a second chip 402, a third chip 403, and a fourth chip 404. The first chip 401, the second chip 402, the third chip 403, and the fourth chip 404 may be distinguished into a channel 0 and a channel 1. As illustrated in FIG. 4, respective starting word lines of the first chip 401, the second chip 402, the third chip 403, and the fourth chip 404 may be different from each other.

Specifically, a first starting word line 411 of a block 0 that is a first target block corresponding to the first chip 401 may be or may correspond to a starting word line corresponding to a first position from an uppermost word line of the first target block. Alternatively or additionally, a second starting word line 412 of a block 0 that is a second target block corresponding to the second chip 402 may be a starting word line corresponding to a second position from an uppermost word line of the second target block. A third starting word line 413 corresponding to the third chip 403 and a fourth starting word line 414 corresponding to the fourth chip 404 may be identified similarly. The first position, the second position, a third position, and a fourth position which correspond to the first starting word line 411, the second starting word line 412, the third starting word line 413, and the fourth starting word line 414, respectively, may be different from each other.

According to some example embodiments, in order to perform the program operation according to the first program command from the plurality of starting word lines at the different positions in the plurality of target blocks, a program operation according to a second program command may be performed in advance. Since the program operation according to the second program command precedes the program operation according to the first program command, the program operation according to the second program command may be referred to as a pre-program operation. In this regard, the memory controller 100 may generate the second program command which includes information on a plurality of edge word lines at equal positions in the plurality of target blocks corresponding to the plurality of chips and transmit the second program command to the memory device 110. Here, the second program command may be a program command for ordering a program operation from the plurality of edge word lines to a plurality of ending word lines. The plurality of ending word lines may correspond to the plurality of starting word lines which is associated with the first program command.

Referring to FIG. 4, the second program command may be or may correspond to a program command for ordering a program operation from a first edge word line 421 to a first ending word line of the first target block, a program operation from a second edge word line 422 to a second ending word line of the second target block, and a program operation from a third edge word line 423 to a third ending word line of a third target block. For example the first ending word line may correspond to the first starting word line 411. The second ending word line may correspond to the second starting word line 412. The third ending word line may correspond to the third starting word line 413. In contrast, since the fourth starting word line 414 according to some example embodiments is an uppermost word line of a fourth target block, the program operation according to the second program command may not be performed in the fourth target block.

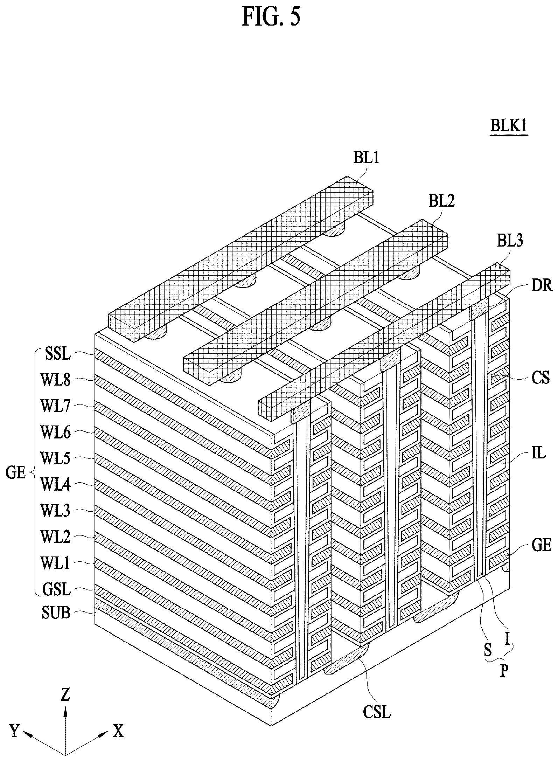

FIG. 5 is a perspective diagram illustrating a block included in a chip according to some example embodiments.

Referring to FIG. 5, a first target block BLK1 may be formed in a direction perpendicular to a substrate SUB. FIG. 5 illustrates that the first target block BLK1 includes two selection lines GSL and SSL, eight word lines WL1 to WL8, and three bit lines BL1 to BL3. However, a larger or smaller number of the above-described elements may be included in general.

The substrate SUB may receive a common source line CSL having a first conductivity type (e.g., a p type), extended in a first direction (e.g., a Y-direction), and doped with impurities of a second conductivity type (e.g., an n type). A plurality of insulation films IL extended in the first direction may be sequentially provided on an area of the substrate SUB between two adjacent common source lines CSL in a third direction (e.g., a Z-direction). The plurality of insulation films IL may be spaced apart by a distance such as a variably-determined (or, alternatively, a predetermined) distance in the third direction. For example, the plurality of insulation films IL may include an insulation material such as silicon oxide.

A plurality of pillars P sequentially disposed in the first direction and penetrating the plurality of insulation films IL in the third direction may be provided on the area of the substrate SUB between the two common source lines CSL. For example, the plurality of pillars P may penetrate the plurality of insulation films IL to be in contact with the substrate SUB. Specifically, a surface layer S of each pillar P may include a silicon material having a first type and function as a channel area. Meanwhile, an inner layer I of each pillar P may include the insulation material such as silicon oxide or an air gap.

A charge storage layer CS may be provided along an exposed surface of the insulation films IL, the pillars P, and the substrate SUB in the area between the two adjacent common source lines CSL. The charge storage layer CS may include a gate insulation layer (alternatively referred to as a tunneling insulation layer), a charge trap layer, and a blocking insulation layer. For example, the charge storage layer CS may have a oxide-nitride-oxide (ONO) structure. In some example embodiments, a gate electrode such as the selection lines GSL and SSL and the word lines WL1 to WL8 may be provided on an exposed surface of the storage charge storage layer CS in the area between the two adjacent common source lines.

Drains DR or drain contacts each may be provided on the plurality of pillars P. For example, the drains DR or the drain contacts may include a silicon material doped with impurities having the second conductivity type. The bit lines BL1 to BL3 which are extended in a second direction (e.g., an X-direction) and disposed to be spaced apart by a predetermined distance in the first direction may be provided on the drains DR.

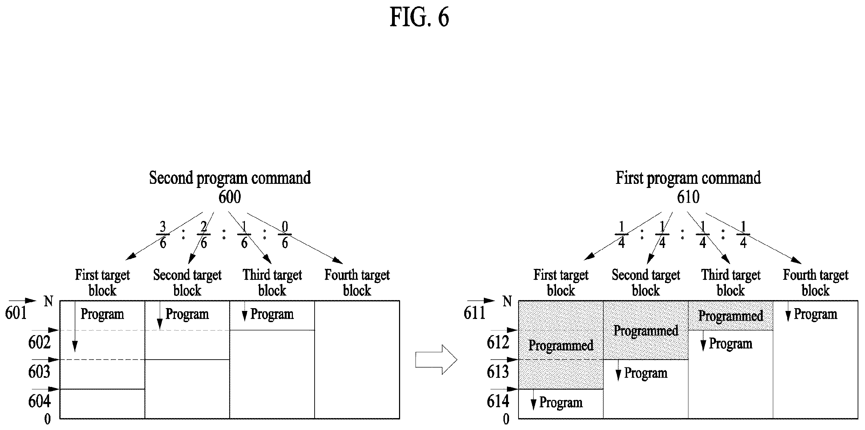

FIG. 6 is a diagram for describing a program operation according to a second program command and a program operation according to a first program command according to some example embodiments. A target block in FIGS. 6 through 9 may be divided into zeroth to N-th word lines.

In response to receiving a host program command from a host, the memory controller 100 may generate a program command for ordering a program operation for the plurality of chips 111 included in the memory device 110. In this regard, the memory controller 100 may sequentially generate the second program command and the first program command and may control the program operation for the plurality of chips 111.

According to some example embodiments, the memory controller 100 may generate a second program command 600 including information on a plurality of edge word lines at equal positions in a plurality of target blocks and transmit the second program command 600 to the memory device 110. Here, the second program command 600 may include information on a set ratio corresponding to the number of word lines to be programmed in each of the plurality of chips 111. In this regard, a ratio set for each of the plurality of target blocks which corresponds to the plurality of chips 111 may have a value different from another. For example, the memory controller 100 may perform control through the second program command 600 so that the number of word lines programmed in each of the plurality of target blocks is different from another. In this regard, positions of a plurality of ending word lines after a program operation according to the second program command 600 being completed may be different positions.

Referring to FIG. 6, a first ratio that is a ratio set for a first target block may be 3/6. A second ratio that is a ratio set for a second target block may be 2/6. A third ratio that is a ratio set for a third target block may be 1/6. A fourth ratio that is a ratio set for a fourth target block may be 0/6. The first ratio may correspond to the number of word lines between a first ending word line 604 and an uppermost word line 601. The second ratio may correspond to the number of word lines between a second ending word line 603 and the uppermost word line 601. The third ratio may correspond to the number of word lines between a third ending word line 602 and the uppermost word line 601. In contrast, since the program operation according to the second program command 600 is not performed for the fourth target block, a fourth ending word line corresponding to the fourth target block may correspond to the uppermost word line 601.

According to some example embodiments, the memory controller 100 may generate a first program command 610 including information on a plurality of starting word lines at different positions in the plurality of target blocks and transmit the first program command 610 to the memory device 110. A first starting word line 614 may correspond to the first ending word line 604. A second starting word line 613 may correspond to the second ending word line 603. A third starting word line 612 may correspond to the third ending word line 602. A fourth starting word line and the fourth ending word line may correspond to uppermost word lines 601 and 611.

Here, the first program command 610 may include information on a set ratio corresponding to the number of word lines to be programmed in each of the plurality of chips. In this regard, a ratio set for each of the plurality of target blocks which corresponds to the plurality of chips may have an equal value. For example, the memory controller 100 may perform control through the first program command 610 so that an interval between word lines programmed individually in the plurality of target blocks is maintained at a time of a program operation.

Referring to FIG. 6, all of a first ratio that is a ratio set for the first target block, a second ratio that is a ratio set for the second target block, a third ratio that is a ratio set for the third target block, and a fourth ratio that is a ratio set for the fourth target block may be 1/4. When the program operation which is for the first target block is completed, the second ratio which is the ratio set for the second target block, the third ratio which is the ratio set for the third target block, and the fourth ratio which is the ratio set for the fourth target block may be changed to 1/3. In other words, as the program operation which is for a target block is completed, a ratio set for another target block may be appropriately changed. As a result, as the program operation which is for the fourth target block is completed, the program operation which is for the first target block, the second target block, the third target block, and the fourth target block may end.

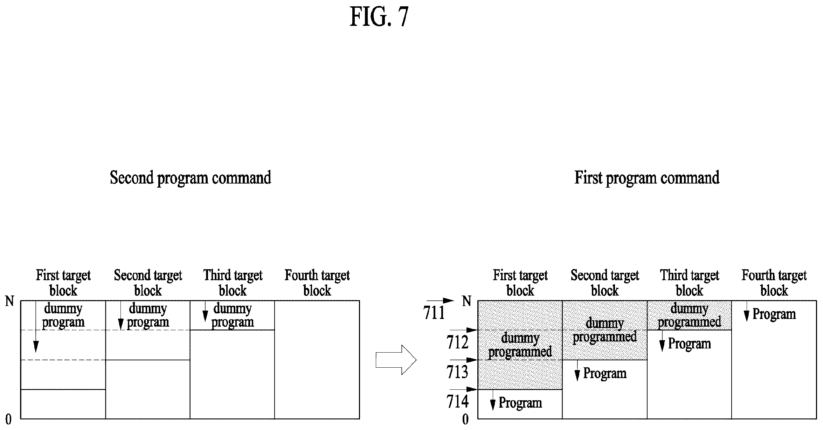

FIG. 7 is a diagram for describing a program operation according to a second program command and a program operation according to a first program command according to some example embodiments.

In response to receiving a host program command from a host, the memory controller 100 may generate a program command for ordering a program operation for the plurality of chips 111 included in the memory device 110. In this regard, the memory controller 100 may sequentially generate the second program command and the first program command and control the program operation for the plurality of chips 111. Redundant descriptions of the program operation according to the second program command and the program operation according to the first program command of FIG. 7, which are similar to those of FIG. 6, will be omitted.

Unlike FIG. 6, data programmed in a plurality of target blocks according to the program operation according to the second program command of FIG. 7 may be dummy data. In the present disclosure, the dummy data may represent randomly generated data, not actual data to be stored in a memory cell. Referring to FIG. 7, all of data programmed in a word line between an uppermost word line 711 and a first starting word line 714 of a first target block, data programmed in a word line between the uppermost word line 711 and a second starting word line 713 of a second target block, and data programmed in a word line between the uppermost word line 711 and a third starting word line 712 of a third target block may be the dummy data.

In this regard, after the program operation according to the first program command ends, an erasure operation for a memory cell in which the dummy data is programmed and a program operation for a word line in which the dummy data is erased may follow. In this regard, the memory controller 100 may sequentially generate an erasure command and a third program command and sequentially control the erasure operation according to the erasure command and the program operation according to the third program command.

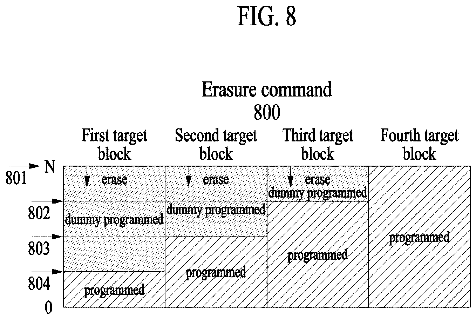

FIG. 8 is a diagram for describing an erasure operation according to an erasure command according to some example embodiments.

Each of a plurality of target blocks of FIG. 8 may show a state after a program operation according to a first program command being completed. That is, all memory cells included in the plurality of target blocks may be programmed. However, dummy data may be programmed in some memory cells included in the plurality of target blocks.

According to some example embodiments, the memory controller 100 may generate an erasure command 800 including information on a word line programmed based on a second program command and transmit the erasure command 800 to a memory device. In this regard, the memory controller 100 may control the erasure operation for the dummy data which is programmed in the plurality of chips 111. Here, the erasure command 800 may include information on an edge word line and information on a starting word line for each of the plurality of chips 111. For example, the memory controller 100 may control the erasure operation for a word line, in which the dummy data is programmed, for each of the plurality of target blocks by transmitting the erasure command 800 to the memory device 110.

Referring to FIG. 8, the dummy data which is programmed in a memory cell between an uppermost word line 801 and a first starting word line 804 of a first target block may be removed by the erasure operation according to the erasure command. Similarly, the dummy data which is stored in a memory cell between the uppermost word line 801 and a second starting word line 803 of a second target block and the dummy data which is stored in a memory cell between the uppermost word line 801 and a third starting word line 802 may be removed by the erasure operation according to the erasure command.

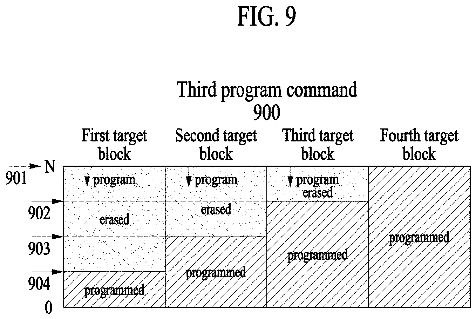

FIG. 9 is a diagram for describing a program operation according to a third program command according to some example embodiments.

Each of a plurality of target blocks of FIG. 9 may show a state after an erasure operation according to an erasure command being completed. In other words, a data cell in which dummy data is removed by the erasure operation among memory cells included in the plurality of target blocks may be empty.

According to some example embodiments, the memory controller 100 may generate a third program command 900 including information on a word line in which the dummy data is erased through the erasure operation according to the erasure command and transmit the third program command 900 to the memory device 110. Here, the third program command 900 may include information on a plurality of edge word lines at equal positions in the plurality of target blocks and information on a set ratio corresponding to the number of word lines to be programmed in each of a plurality of chips. Here, the information on the plurality of edge word lines may correspond to information on a plurality of edge word lines, which is included in a second program command. Also, the information on the set ratio corresponding to the number of the word lines to be programmed in each of the plurality of chips may correspond to information on a set ratio corresponding to the number of word lines to be programmed in each of the plurality of chips, which is included in the second program command. For example, the memory controller 100 may control the program operation for each of the plurality of target blocks by transmitting the third program command 900 to the memory device 110.

Referring to FIG. 9, a first ratio that is a ratio set for a first target block may be 3/6. A second ratio that is a ratio set for a second target block may be 2/6. A third ratio that is a ratio set for a third target block may be 1/6. A fourth ratio that is a ratio set for a fourth target block may be 0/6. In this regard, the memory controller 100 may control, through the third program command 900, a program operation from an uppermost word line 901 to a word line 904 of the first target block, a program operation from the uppermost word line 901 to a word line 903 of the second target block, and a program operation from the uppermost word line 901 to a word line 902 of the third target block.

However, the erasure operation according to the erasure command and the program operation according to the third program command are not limited to example embodiments illustrated in FIGS. 8 and 9. For example, a program operation according to a first program command may be completed in sequential order from the first target block to the fourth target block. In this regard, the memory controller 100 may immediately generate the erasure command for a target block for which the program operation is completed and transmit the erasure command to the memory device 110. In other words, the memory controller 100 may perform control so that the erasure operation is completed earlier for a target block for which the program operation according to the first program command is completed. Accordingly, a time at which the program operation according to the third program command starts for each of the plurality of target blocks may be also different from another.

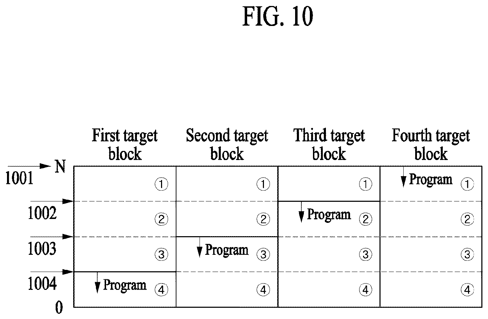

FIG. 10 is a diagram for describing a method with which a memory controller controls a program operation for a plurality of chips when a target block according to some example embodiments includes a plurality of sub-blocks.

According to some example embodiments, in order to perform a program operation according to a first program command from a plurality of starting word lines at different positions in a plurality of target blocks, a program operation according to a second program command may not be necessarily performed in advance. That is, although a pre-program operation does not precede the program operation according to the first program command, the memory controller 100 may perform control so that the plurality of target blocks is programmed from the plurality of starting word lines at the different positions in the plurality of target blocks.

According to some example embodiments, when a block is divided into a plurality of sub-blocks, the program operation may be performed in a unit smaller than the block. For example, efficiency of a program operation for the memory device 110 may be increased. Alternatively or additionally, when the block is divided into the plurality of sub-blocks, durability of the block may be improved or excellent in general. In contrast, when the block is divided into the plurality of sub-blocks, there is concern that inefficiency of a memory capacity is increased and that a manufacturing cost is also increased. For example, whether the block is divided into the plurality of sub-blocks may differ depending on a purpose of designing the memory device 110.

According to some example embodiments, each of the plurality of target blocks may include a plurality of sub-blocks. For example, referring to FIG. 10, a first target block, a second target block, a third target block, and a fourth target block each may include four sub-blocks. At this point, the plurality of starting word lines may correspond to one of a plurality of edge word lines in the plurality of sub-blocks included in each of the plurality of target blocks. In other words, when the target block includes the plurality of sub-blocks, the memory controller 100 may perform control so that the program operation is performed with a middle word line, other than an edge word line of the target block, as a starting word line. A first starting word line 1004 of the first target block may correspond to an uppermost word line of a fourth sub-block of the first target block. Similarly, a second starting word line 1003 of the second target block may correspond to an uppermost word line of a third sub-block of the second target block. A third starting word line 1002 of the third target block may correspond to an uppermost word line of a second sub-block of the third target block. A fourth starting word line 1001 of the fourth target block may correspond to an uppermost word line of a first sub-block of the fourth target block.

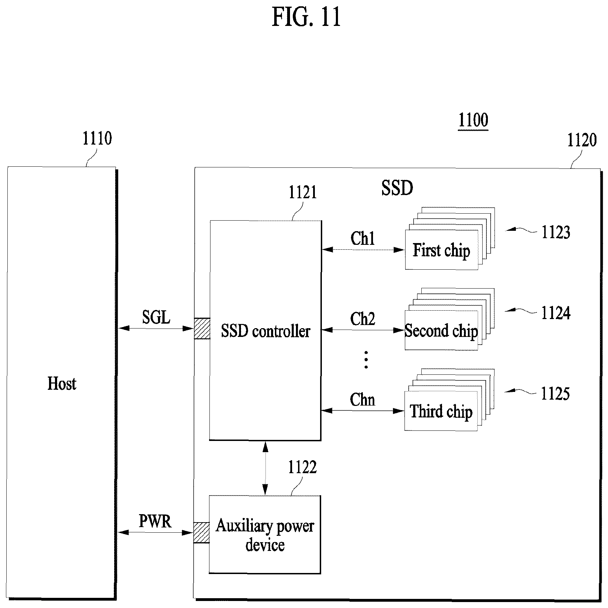

FIG. 11 is a block diagram illustrating an example in which a memory device according to some example embodiments is applied to a solid state drive (SSD) system.

Referring to FIG. 11, an SSD system 1100 may include a host 1110 and an SSD 1120. The SSD 1120 may send and receive a signal to and from the host 1110 through a signal connector and may receive an input of power through a power connector. The SSD 1120 may include an SSD controller 1121, an auxiliary power device 1122, and a plurality of memory devices 1123, 1124, and 1125. At this point, the SSD 1120 may correspond to the memory system 200 of the present disclosure. The SSD controller 1121 may correspond to the memory controller 100. Each of the plurality of memory devices 1123, 1124, and 1125 may correspond to the memory device 110.

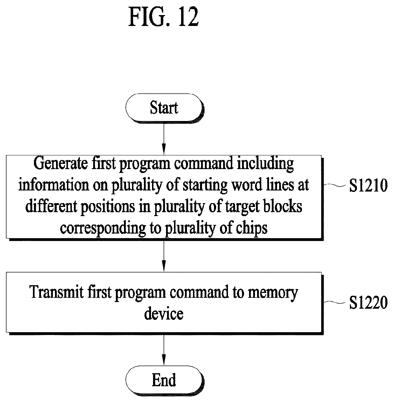

FIG. 12 is a flowchart for describing an operation method of a memory controller according to some example embodiments.

Since each operation of an operation method of FIG. 12 may be performed by the memory controller 100, redundant descriptions similar to those of FIGS. 1 through 11 will be omitted. Here, the memory controller 100 may include the processor 101 and the memory interface 102.

In operation S1210, the memory controller 100 may generate a first program command including information on a plurality of starting word lines at different positions in a plurality of target blocks corresponding to a plurality of chips.

In response to receiving a host program command from a host, the memory controller 100 according to some example embodiments may generate a program command for ordering a program operation for the plurality of chips 111 included in the memory device 110. Here, the first program command may be a program command for ordering the program operation in a first direction or a second direction from the plurality of starting word lines which corresponds to the plurality of target blocks.

In operation S1220, the memory controller 100 may transmit the first program command to the memory device 110.

The memory controller 100 according to some example embodiments may control the memory device 110 so that the memory device 110 is programmed in the first direction or the second direction from the plurality of starting word lines.

The memory controller 100 according to the above-described example embodiments may include a processor, a memory that stores and executes program data, a permanent storage such as a disk drive, a communication port for communicating with an external device, and a user interface device such as a touch panel, a key, and a button. Methods implemented by software modules or algorithms may be stored in a computer-readable recording medium as computer-readable code or program instructions executable in the processor. Here, the computer-readable recording medium may include one or more of a magnetic storage medium (e.g., a read-only memory (ROM), a random-access memory (RAM), a floppy disk, a hard disk, or the like), an optical reading medium (e.g., a CD-ROM or a digital versatile disc (DVD)), or the like. The computer-readable recording medium may be dispersed to computer systems connected by a network so that computer-readable codes may be stored and executed in a dispersed manner. The medium may be read by a computer, stored in the memory, and executed by the processor.

Some example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as one or more of C, C++, Java, and assembler language, including various algorithms implemented by combinations of data structures, processes, routines, or of other programming configurations. Functional aspects may be implemented by algorithms executed by one or more processors. Alternatively or additionally, some example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

## Claims

1. An operation method of a memory controller (100) configured to control a memory device (110) including a plurality of chips (401-404), the operation method comprising:
generating (S1210) a first program command (610) including information on a plurality of starting word lines (411-414) at different positions in a plurality of target blocks corresponding to the plurality of chips (401-404); and
transmitting (S1220) the first program command (610) to the memory device (110).

2. The operation method of claim 1, wherein
a first starting word line (411) of a first target block corresponding to a first chip (401) among the plurality of chips (401-404) is a starting word line corresponding to a first position from an uppermost word line of the first target block,
a second starting word line (412) of a second target block corresponding to a second chip (402) among the plurality of chips (401-404) is a starting word line corresponding to a second position from an uppermost word line of the second target block, and
the first position and the second position are different positions.

3. The operation method of claim 2, wherein a number of word lines between a word line corresponding to the first position and a word line corresponding to the second position is greater than or equal to a number stored in at least one of the memory controller (100) or at least one of the plurality of chips (401-404).

4. The operation method of any one of claims 1 to 3, wherein the first program command (610) includes a program command to order a program operation in a first direction or a second direction, the program operation starting from the plurality of starting word lines (411-414) which corresponds to the plurality of target blocks.

5. The operation method of any one of claims 1 to 4, wherein
the first program command (610) includes information on a set ratio corresponding to a number of word lines to be programmed in each of the plurality of chips (401-404), and
a first ratio set for a first chip (401) among the plurality of chips (401-404) and a second ratio set for a second chip (402) among the plurality of chips (401-404) correspond to an equal value.

6. The operation method of any one of claims 1 to 5, further comprising:
generating a second program command (600) including information on a plurality of edge word lines (421-423) at equal positions in the plurality of target blocks corresponding to the plurality of chips (401-404); and
transmitting the second program command (600) to the memory device (110).

7. The operation method of claim 6, wherein the second program command (600) includes a program command ordering a program operation from the plurality of edge word lines (421-423) to a plurality of ending word lines.

8. The operation method of claim 7, wherein the plurality of ending word lines corresponds to the plurality of starting word lines (411-414).

9. The operation method of claim 7 or 8, wherein
the second program command (600) includes information on a set ratio corresponding to a number of word lines to be programmed in each of the plurality of chips (401-404), and
a first ratio that is set for a first chip (401) among the plurality of chips (401-404) and a second ratio that is set for a second chip (402) among the plurality of chips (401-404) correspond to different values.

10. The operation method of any one of claims 7 to 9, further comprising:
programming dummy data in a word line programmed based on the second program command (600).

11. The operation method of claim 10, further comprising:
generating an erasure command (800) including information on the word line programmed based on the second program command (600); and
transmitting the erasure command (800) to the memory device (110).

12. The operation method of claim 11, further comprising:
generating a third program command (900) including the word line in which the dummy data is erased through an erasure operation according to the erasure command (800); and
transmitting the third program command (900) to the memory device (110).

13. The operation method of any one of claims 1 to 12, wherein in response to each of the plurality of target blocks including a plurality of sub-blocks, a first starting word line (411) of a first target block corresponding to a first chip (401) among the plurality of chips corresponds to one of a plurality of edge word lines (1001-1004) in the plurality of sub-blocks which is included in the first target block.

14. A memory controller (100) configured to control a memory device (110) comprising a plurality of chips (401-404), the memory controller (100) comprising:
a memory interface (102) configured to communicate with the memory device (110); and
a processor (101) configured to generate a first program command (610) comprising information on a plurality of starting word lines (411-414) in a plurality of target blocks at different positions, the plurality of target blocks corresponding to the plurality of chips (401-404), the processor (101) configured to transmit the first program command (610) to the memory device (110) through the memory interface (102).

15. A memory system (200) comprising:
a memory device (110) comprising a plurality of chips (401-404); and
a memory controller (100) according to claim 14, wherein each of the plurality of chips (401-404) comprises a plurality of blocks.
